Europäisches Patentamt

European Patent Office

Office européen des brevets

(11) Veröffentlichungsnummer: **0 216 178
B1**

(12) **EUROPÄISCHE PATENTSCHRIFT**

(45) Veröffentlichungstag der Patentschrift:
**04.07.90**

(51) Int. Cl.⁵: **H03K 19/017**

(21) Anmeldenummer: **86111837.0**

(22) Anmeldetag: **27.08.86**

(54) **C-MOS-Eingangsschaltung.**

(30) Priorität: **29.08.85 DE 3530917**

(43) Veröffentlichungstag der Anmeldung:
**01.04.87 Patentblatt 87/14**

(45) Bekanntmachung des Hinweises auf die Patenterteilung:
**04.07.90 Patentblatt 90/27**

(84) Benannte Vertragsstaaten:
**AT BE CH DE FR GB IT LI NL SE**

(56) Entgegenhaltungen:
**FR-A- 2 296 307
US-A- 4 498 021**

**PATENTS ABSTRACTS OF JAPAN, Band 7,
Nr. 218 (E-200)[1363], 28. September 1983; &
JP-A-58 111 525 (HITACHI SEISAKUSHO
K.K.) 02-07-1983
PATENTS ABSTRACTS OF JAPAN, Band 7,
Nr. 226 (E-202)[1371], 7. Oktober 1983; &
JP-A-58 117 729 (FUJITSU K.K.) 13-07-1983
ELECTRONIC DESIGN, Band 30, Nr. 23, November 1982,
Seiten 171,172, Denville, New Jersey, US; B.L. DOKIC:
"CMOS transistors widen comparator's range"
PATENTS ABSTRACTS OF JAPAN, Band 8,
Nr. 39 (E-228)[1476], 21. Februar 1984; &
JP-A-58 196 725 (HITACHI SEISAKUSHO
K.K.) 16-11-1983**

(73) Patentinhaber: **Siemens Aktiengesellschaft,
Wittelsbacherplatz 2, D-8000 München 2(DE)**

(72) Erfinder: **Sichart von, Frithjof, Dr., Karl
Theodorstrasse 72, D-8000 München 40(DE)**

## Beschreibung

Beim Einsatz von C-MOS-Schaltungen ist zu beachten, daß das Eingangspotential von unbeschalteten - oder auch mit im Ruhezustand befindlichen Tristate-Schaltungen beschalteten - C-MOS-Schaltungseingängen nicht definiert ist, so daß die C-MOS-Transistoren in undefinierte Betriebszustände gelangen und falsche Ausgangssignale erzeugen können; um dies zu vermeiden, sind momentan unbenutzte C-MOS-Schaltungseingänge mit der einen oder der anderen Betriebspotentialquelle der C-MOS-Schaltung zu verbinden, was mit Hilfe eines entsprechend dimensionierten ohmschen (pull-up- bzw. pull-down-) widerstands geschehen kann (McMOS Handbook, Motorola Inc., Oct. 1973, page 6.15, chapter 6.B.4).

Damit wird dann zugleich auch dem mit undefinierten Eingangspotentialen von C-MOS-Schaltungen verbundenen weiteren Problem begegnet, daß dann, wenn ein solches Eingangspotential in einen kritischen Bereich zwischen dem Schwellspannungswert der p-Kanal-Transistoren und dem Schwellspannungswert der n-Kanal-Transistoren gelangt, sowohl p-Kanal-Transistoren als auch n-Kanal-Transistoren gut leitend sein und dann von hohen Strömen durchflossen werden können, durch die sie nach kurzer Zeit zerstört werden.

Solche ohmsche pull-up-bzw. pull-down-Widerstände können in Form von externen Bauelementen vorgesehen sein, mit denen die betreffenden C-MOS-Schaltungseingänge beschaltet werden. Eine solche externe Beschaltung ist allerdings aus Platzgründen oftmals nicht möglich. Andererseits läßt an sich mögliche Integration von ohmschen pull-up-bzw. pull-down-Widerständen in die Eingangsstrukturen von C-MOS-Schaltungen wegen der dann ständig gegebenen ohmschen Verbindung der Eingangsknoten mit einer festen Potentialquelle eine für das Testen und die technologische Beurteilung von C-MOS-Schaltungen außerordentlich wichtige Messung, nämlich die Messung der Eingangssperrströme, nicht mehr zu.

Die Erfindung stellt sich nun die Aufgabe, eine C-MOS-Eingangsschaltung anzugeben, die einerseits integrationsfähig ist, andererseits aber auch eine solche Messung von Eingangssperrströmen ermöglicht.

Die Erfindung betrifft eine C-MOS-Eingangsschaltung mit einem zwischen dem C-MOS-Schaltungs-Eingang und einer Betriebspotentialquelle liegenden pull-up- bzw. pull-down-Widerstand zur Festlegung des Eingangspotentials des unbeschalteten Schaltungseingangs, wobei der pull-up- bzw. pull-down-Widerstand durch eine einen vom Schaltungseingang her gesteuerten geschalteten Widerstand bildende MOS-Transistorschaltung gebildet ist, die nur in einem über einer Schaltschwelle liegenden Bereich des Eingangspotentials am Schaltungseingang leitfähig ist; diese C-MOS-Eingangsschaltung ist erfindungsgemäß dadurch gekennzeichnet, daß der pull-up- bzw. pull-down-Widerstand durch eine nur in einem zwischen zwei Transistor-Schaltschwellen liegenden mittleren Bereich des Schaltungseingangspotentials leitfähige MOS-Transistorschaltung gebildet ist, deren eine Schaltschwelle nahe bei der Schwellspannung der MOS-Transistoren des einen Kanaltyps liegt und deren andere Schaltschwelle nahe bei der Schwellspannung der MOS-Transistoren des anderen Kanaltyps liegt.

Die Erfindung bringt den Vorteil mit sich, sowohl die Eingangsschaltung in die nachfolgende eigentliche C-MOS-Schaltung integrieren zu können als auch die gesamte C-MOS-Schaltung einer Messung des – in der Größenordnung von weniger als 1 µA liegenden – Eingangssperrstroms unterziehen und damit ein Kriterium für die Ausfallanfähigkeit der C-MOS-Schaltung erhalten zu können.

Es sei an dieser Stelle zunächst bemerkt, daß (aus dem JP A 58-117 729-Patent Abstract, Patents Abstracts of Japan, Vol. 7, No. 226 (E-202) (1371), Oct. 7, 1983) eine CMOS-Eingangsschaltung mit einem zwischen dem CMOS-Schaltungs-Eingang und einer Betriebspotentialquelle liegenden pull-up-Widerstand zur Festlegung des Eingangspotentials des unbeschalteten Schaltungseingangs bekannt ist, bei der der pull-up-Widerstand durch eine einen vom Schaltungseingang her gesteuerten Widerstand bildende, nur in einem über einer Schaltschwelle liegenden Bereich des Eingangspotentials am Schaltungseingang leitfähige MOS-Transistorschaltung gebildet ist, wobei diese Schaltschwelle durch die Schwellspannung eines Inverters gegeben ist; nähere Berührungspunkte mit der Erfindung und der ihr zugrundeliegenden Aufgabenstellung sind indessen nicht gegeben.

Es sei ferner bemerkt, daß es (aus US-A 4 498 021) bekannt ist, zur Versteilerung der Signalflanken auf einer zwischen einer Digitalsignalsendeschaltung und einer Digitalsignalempfangsschaltung verlaufenden, kapazitätsbehafteten Signalleitung in einem C-MOS-IC eine Boosterschaltung vorzusehen, bei der eine zwischen der Signalleitung und einer Betriebspotentialquelle liegende, mit zwei MOS Transistoren gleichen Kanaltyps gebildete und von der Signalleitung her über drei C-MOS-Inverter und ein RS-Flip Flop gesteuerte MOS-Transistorschaltung nur in der Zeitspanne zwischen zwei Zeitpunkten leitfähig ist, zu denen von einer Signalflanke zwei in der Nähe des halben Betriebspotentials liegende Schaltschwellen überlaufen werden, um in dieser Zeitspanne in die Signalleitung einen flankenversteilernden Stromimpuls einzuspeisen.

Diese bekannte Boosterschaltung mit in der Nähe des halben Betriebspotentials und somit nicht gerade nahe bei den Schwellspannungen der MOS-Transistoren der beiden Kanaltypen liegenden Schaltschwellen ist im Inneren eines C-MOS-ICs zwischen einer Sendeschaltung und einer Empfangsschaltung vorgesehen und stellt weder eine C-MOS-Eingangsschaltung mit einem zwischen dem C-MOS-Schaltungs-Eingang und einer Betriebspotentialquelle liegenden pull-up- bzw. pull-down-Widerstand zur Festlegung des Eingangspotentials des unbeschalteten Schaltungseingangs dar, noch macht sie es möglich, die gesamte C-MOS-Schaltung einer Messung des Eingangssperrstroms unterziehen zu können, wie dies aber gerade durch die Erfindung ermöglicht wird.

Eine ebenfalls nur kurzzeitig während des Auftretens einer positiven oder negativen Signalflanke (1-0- oder 0-1-Übergang) leitende Transistorschaltung mit zwei MOS-Transistoren gleichen oder entgegengesetzten Kanaltyps ist auch aus der JP-A 58-111 525 bekannt; auch diese bekannte Schaltungsanordnung läßt die Problematik des Auftretens unzulässiger Potentiale am unbeschalteten Eingang einer C-MOS-Schaltung und das Erfordernis der Messung von Eingangssperrströmen von C-MOS-Schaltungen unberührt.

Um nun auf die Erfindung zurückzukommen, so kann in weiterer Ausgestaltung der Erfindung der pull-up- bzw. pull-down-Widerstand durch zwei in Serie geschaltete C-MOS-Transistoren gebildet sein, die von zwei eingangsseitig an den Schaltungseingang angeschlossenen, entgegengesetzt unsymmetrischen C-MOS-Invertern gesteuert werden;
alternativ dazu kann auch der pull-up- bzw. pull-down-Widerstand durch zwei in Serie geschaltete MOS-Transistoren gleichen Kanaltyps gebildet sein, die von zwei eingangsseitig an den Schaltungseingang angeschlossenen, entgegengesetzt unsymmetrischen C-MOS-Invertern direkt bzw. über einen Negator gesteuert werden.

In beiden Fällen werden zweckmäßigerweise die zwei C-MOS-Inverter derart entgegengesetzt unsymmetrisch ausgebildet, daß das dem Verhältnis der Quotienten W/L jeweils aus Kanalweite W und Kanallänge L des einen bzw. des anderen Transistors entsprechende Widerstandsverhältnis der beiden - leitenden - Transistoren bei dem einen C-MOS-Inverter gross gegen Eins und bei dem anderen C-MOS-Inverter klein gegen Eins ist.

Weitere Besonderheiten der Erfindung werden aus der nachfolgenden näheren Erläuterung der Erfindung anhand der Zeichnung ersichtlich. Dabei zeigt

FIG 1 ein Ausführungsbeispiel einer C-MOS-Eingangsschaltung gemäß der Erfindung; in
FIG 2 ist eine Alternative einer solchen C-MOS-Eingangsschaltung angedeutet.
FIG 3 verdeutlicht Signalverläufe in solchen C-MOS-Eingangsschaltungen;
FIG 4 und FIG 5 verdeutlichen das Leitfähigkeitsverhalten des geschalteten pull-up- bzw. pull-down-Widerstands in der C-MOS-Eingangsschaltung nach FIG 1 bzw. FIG 2.

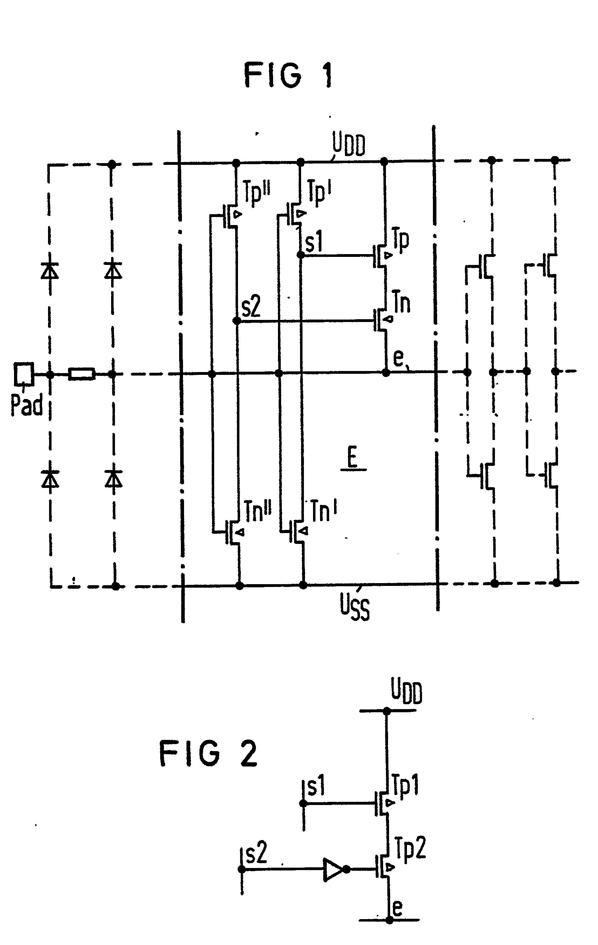

In der Zeichnung FIG 1 ist ein Ausführungsbeispiel einer C-MOS-Eingangsschaltung gemäß der Erfindung dargestellt. Diese C-MOS-Eingangsschaltung E weist einen den C-MOS-Schaltungs-Eingang e mit der $U_{DD}$-Potentialleitung verbindenden, geschalteten pull-up-Widerstand auf, der durch die Serienschaltung eines p-Kanal-Transistors Tp und eines n-Kanal-Transistors Tn gebildet ist; diese zwei C-MOS-Transistoren Tp und Tn werden dabei von zwei mit ihren Eingängen am Schaltungseingang e liegenden C-MOS-Invertern Tp', Tn' und Tp", Tn" gesteuert.

An die C-MOS-Eingangsschaltung E möge sich die eigentliche C-MOS-Schaltung anschließen; in FIG 1 ist dazu angedeutet, daß am Anfang dieser C-MOS-Schaltung ein mit zwei C-MOS-Invertern gebildeter Eingangsverstärker liegen kann. Auf der anderen Seite möge der C-MOS-Eingangsschaltung E eine übliche (ebenfalls integrierte) Überspannungsschutzschaltung vorgeschaltet sein, wie dies ebenfalls in FIG 1 angedeutet ist. Mit Pad ist dann in FIG 1 der von aussen zugängliche Anschlussflecken auf der Randzone der integrierten Schaltung bezeichnet, an welchem bei einem Testen der integrierten Schaltung der von der Betriebspotentialleitung $U_{DD}$ her bzw. der zu der Betriebspotentialleitung $U_{SS}$ hin fliessende Eingangssperrstrom zu messen ist.

In der C-MOS-Eingangsschaltung E sind beide C-MOS-Inverter Tp', Tn' und Tp", Tn" stark unsymmetrisch ausgebildet, dergestalt, daß das dem Verhältnis der Quotienten W/L jeweils aus Kanalweite W und Kanallänge L des einen bzw des anderen Transistors entsprechende Widerstandsverhältnis der beiden - leitenden - Transistoren bei dem einen C-MOS-Inverter groß gegen Eins und bei dem anderen C=MOS-Inverter klein gegen Eins ist. Beispielsweise mögen der p-Kanal-Transistor Tp' des einen C-MOS-Inverters und der n-Kanal-Transistor Tn" des anderen C-MOS-Inverters ein Kanalweite/Kanallänge-Verhältnis W/L = 0,2 aufweisen, während der n-Kanal-Transistor Tn' des einen C-MOS-Inverters und der p-Kanal-Transistor Tp" des anderen C-MOS-Inverters beispielsweise ein Kanalweite/Kanallänge-Verhältnis W/L = 5 oder auch W/L = 20 haben; die beiden den eigentlichen pull-up-Widerstand bildenden C-MOS-Transistoren Tp und Tn mögen jeweils ein Kanalweite/Kanallänge-Verhältnis W/L = 1 aufweisen.

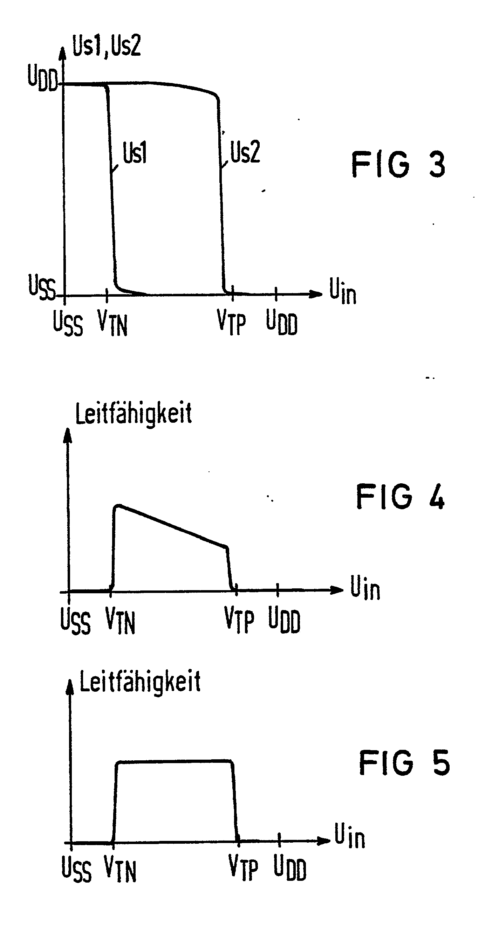

Die an den zwei Ausgängen s1 und s2 der zwei unsymmetrischen C-MOS-Inverter Tp', Tn' und tP", Tn" auftretenden Steuersignale Us1 und Us2 für die den schaltbaren pull-up-Widerstand bildenden zwei Serientransistoren Tp und Tn haben dann die aus FIG 3 ersichtliche prinzipielle Abhängigkeit von einem am Anschlußflecken Pad und damit am Schaltungseingang e auftretenden Eingangspotential $U_{in}$:

Tritt am Anschlussflecken Pad und damit am Schaltungseingang e das $U_{SS}$-Potential oder, allgemeiner gesagt, ein unterhalb des Schwellspannungswerts $V_{TN}$ der n-Kanal-Transistoren der C-MOS-Schaltung bleibendes Potential auf, so sind die p-Kanal-Transistoren Tp' und tP" beider C-MOS-Inverter Tp',Tn' und Tp",Tn" leitend, so daß an beiden Inverterausgängen s1 und s2 das $U_{DD}$-Potential auftritt, auf Grund dessen in der Serienschaltung der beiden Transistoren Tp und Tn der p-Kanal-Transistor Tp nichtleitend und der n-Kanal-Transistor Tn leitend ist; die Transistor-Serienschaltung Tp, Tn insgesamt hat damit einen vernachlässigbar kleinen Leitwert.

Mit Überschreiten des Schwellspannungswertes $V_{TN}$ der n-Kanal-Transistoren der C-MOS-Schaltung (oder allenfalls kurz danach) wird die Schaltschwelle des C-MOS-Inverters Tp',Tn' erreicht, so daß dessen bischer nichtleitender n-Kanal-Transistor Tn' leitend wird; bei den obenangegebenen W/L-Verhältnissen wird sein Widerstand bei 10 kOhm bzw. bei 400 Ohm liegen, wogegen der p-Kanal-Transtor Tp' jetzt hochohmig ist. Der Inverterausgang s1 nimmt demzufolge das $U_{SS}$-Potential an, aufgrund dessen in der Serienschaltung der beiden Transistoren Tp und Tn der p-Kanal-Transistor Tp leitend wird, während der n-Kanal-Transistor Tn weiterhin leitend ist; die Serienschaltung Tp, Tn wirkt damit als pull-up-Widerstand, über den der Schaltungseingang e und damit der Anschluß Pad mit der Betriebspotentialquelle $U_{DD}$ verbunden ist. Steigt das Eingangspotential $U_{in}$ weiter an, so sinkt mit der Gate-Source-Spannung des n-Kanal-Transistors Tn auch dessen Leitfähigkeit und damit auch die Leitfähigkeit der Serienschaltung Tp, Tn insgesamt, deren Verlauf in Abhängigkeit vom Eingangspotential $U_{in}$ in FIG 4 skizziert ist.

Kurz bevor schließlich das Eingangspotential den Schwellspannungswert $V_{TP}$ der p-Kanal-Transistoren der C-MOS-Schaltung erreicht, wird die Schaltschwelle des C-MOS-Inverters Tp", Tn" überschritten, womit dessen bisher leitender p-Kanal-Transistor Tp" gesperrt wird. Über seinen an sich schon seit dem Überschreiten des Schwellspannungswertes $V_{TN}$ leitenden, aber sehr hochomigen n-Kanal-Transistors Tn" - bei den oben angegebenen W/L-Verhältnissen kann sein Widerstand bei 100 kOhm liegen, - nimmt der Inverterausgang s2 demzufolge das $U_{SS}$-Potential an, aufgrund dessen in der Serienschaltung der beiden Transistoren Tp und Tn der n-Kanal-Transistor Tn nichtleitend wird; die Serienschaltung Tp, Tn wirkt damit nicht weiter als pull-up-Widerstand.

Wie man sieht, wirkt die Transistor-Serienschaltung Tp, Tn also nur bei zwischen den Schwellspannungswerten $V_{TN}$ und $V_{TP}$ einer C-MOS-Schaltung liegenden Eingangspotentialen als pull-up-Widerstand und verhindert damit das Auftreten unzulässiger Potentiale bei unbeschaltetem Eingang, während sie bei darunter oder darüber liegenden Potentialen und damit auch bei den üblicherweise zugleich als Steuerpotentiale dienenden Betriebspotentialen $U_{SS}$ und $U_{DD}$ unwirksam bleibt.

In Abweichung von dem im vorstehenden anhand von FIG 1, FIG 3 und FIG 4 erläuterten Ausführungsbeispiel kann der pull-up-Widerstand statt mit zwei C-MOS-Transistoren Tp, Tn (in FIG 1) auch mit zwei MOS-Transistoren gleichen Kanaltyps gebildet sein, beispielsweise mit zwei p-Kanal-Transistoren Tp1 und Tp2, wie dies in FIG 2 angedeutet ist. Dabei ist dann der eine Serientransistor, im Beispiel der Transistor Tp2, mit dem zugehörigen Inverterausgang s2 über einen Negator verbunden, während der andere Serientransistor (Tp1) wie im Ausführungsbeispiel gemäß FIG 1 direkt vom zugehörigen Inverterausgang s1 her angesteuert wird. Da bei einer solchen Realisierung des geschalteten pull-up-Widerstands mit zwei p-Kanal-Transistoren Tp1, Tp2 bei leitenden Transistoren Tp1 und Tp2 die Gate-Source-Spannung des p-Kanal-Transistor Tp2 sich nicht ändert, bleibt dessen Leitfähigkeit und damit die Leitfähigkeit der Serienschaltung Tp1, Tp2 insgesamt im ganzen Wirksamkeitsbereich der Serienschlatung auf gleicher Höhe, wie dies in FIG 5 skizziert ist. Im übrigen gelten die obigen Erläuterungen zum Ausführungsbeispiel gemäß FIG 1 in entsprechender Weise auch für eine C-MOS-Eingangsschaltung, in der der geschaltete Widerstand in der aus FIG 2 ersichtlichen Weise realisiert ist, ohne daß dies erneut ins einzelne gehend dargelegt werden müßte.

Die im vorstehenden erläuterten Ausführungsbeispiele von C-MOS-Eingangsschaltungen gemäß der Erfindung sehen jeweils einen zwischen dem C-MOS-Schaltungseingang und der $U_{DD}$-Potentialquelle liegenden pull-up-Widerstand vor, der gemäß der Erfindung realisiert ist. Es ist jedoch klar, daß in entsprechender Weise auch C-MOS-Eingangsschaltungen mit einem zwischen dem C-MOS-Schaltungseingang und der $U_{SS}$-Potentialquelle liegenden pull-down-Widerstand realisiert werden können, ohne daß dies indessen noch weiter ins einzelne gehend erläutert werden müßte.

**Patentansprüche**

1. C-MOS-Eingangsschaltung mit einem zwischen dem C-MOS-Schaltungs-Eingang und einer Betriebspotentialquelle liegenden pull-up- bzw. pull-down-Widerstand zur Festlegung des Eingangspotentials des unbeschalteten Schaltungseingangs, wobei der pull-up- bzw. pull-down-Widerstand durch eine einen vom Schaltungseingang (e) her gesteuerten geschalteten Widerstand bildende MOS-Transistorschaltung (Tp, Tn) gebildet ist, die nur in einem über einer Schaltschwelle liegenden Bereich des Eingangspotentials am Schaltungseingang leitfähig ist, dadurch gekennzeichnet, daß der pull-up- bzw. pull-down-Widerstand durch eine nur in einem zwischen zwei Transistor-Schaltschwellen liegenden mittleren Bereich des Schaltungseingangspotentials leitfähige MOS-Transistorschaltung (Tp, Tn) gebildet ist, deren eine Schaltschwelle nahe bei der Schwellspannung ($V_{TN}$) der MOS-Transistoren des einen Kanaltyps liegt und deren andere Schaltschwelle nahe bei der Schwellspannung ($V_{TP}$) der MOS-Transistoren des anderen Kanaltyps liegt.

2. C-MOS-Eingangsschaltung nach Anspruch 1, dadurch gekennzeichnet, daß der pull-up- bzw. pull-down-Widerstand durch zwei in Serie geschaltete, von zwei eingangsseitig an den Schaltungseingang (e) angeschlossenen, entgegengesetzt unsymmetrischen C-MOS-Invertern (Tp', Tn'; Tp", Tn") gesteuerte C-MOS-Transistoren (Tp, Tn) gebildet ist.

3. C-MOS-Eingangsschaltung nach Anspruch 1, dadurch gekennzeichnet, daß der pull-up- bzw. pull-down-Widerstand durch zwei in Serie geschaltete, von zwei eingangsseitig an den Schaltungseingang (e) angeschlossenen, entgegengesetzt unsymmetrischen C-MOS-Invertern (Tp', Tn'; Tp", Tn") direkt bzw. über einen Negator gesteuerte MOS-Transistoren gleichen Kanaltyps (Tp1, Tp2) gebildet ist.

4. C-MOS-Eingangsschaltung nach Anspruch 2 oder 3, dadurch gekennzeichnet, daß die beiden C-MOS-Inverter (Tp', Tn'; Tp", Tn") derart entgegengesetzt unsymmetrisch ausgebildet sind, daß das dem Verhältnis der Quotienten (W/L) jeweils aus Kanalweite (W) und Kanallänge (L) des einen bzw. des anderen Transistors entsprechende Widerstandsverhältnis der beiden - leitenden -Transistoren bei dem einen C-MOS-Inverter gross gegen Eins und bei dem anderen C-MOS-Inverter klein gegen Eins ist.

## Claims

1. CMOS input circuit having a pull-up or pull-down resistor lying between the CMOS circuit input and an operating potential source, for the definition of the input potential of the unconnected circuit input, the pull-up or pull-down resistor being formed by an MOS transistor circuit (Tp, Tn) forming a switched resistor controlled from the circuit input (e), which transistor circuit is only conductive in a range of the input potential lying above a switching threshold at the switching input, characterized in that the pull-up or pull-down resistor is formed by an MOS transistor circuit (Tp, Tn) which is only conductive in a central range of the circuit input potential lying between two transistor switching thresholds, the one switching threshold of which lies close to the threshold voltage ($V_{TN}$) of the MOS transistors of the one channel type, and the other switching threshold of which lies close to the threshold voltage ($V_{TP}$) of the MOS transistors of the other channel type.

2. CMOS input circuit according to Claim 1, characterized in that the pull-up or pull-down resistor is formed by two series-connected CMOS transistors (Tp, Tn) which are controlled by two oppositely asymmetrical CMOS inverters (Tp', Tn'; Tp", Tn") connected on the input side to the circuit input (e).

3. CMOS input circuit according to Claim 1, characterized in that the pull-up or pull-down resistor is formed by two series-connected MOS transistors of the same channel type (Tp1, Tp2) which are controlled directly or via a negator by two oppositely asymmetrical CMOS inverters (Tp', Tn'; Tp", Tn") connected on the input side to the circuit input (e).

4. CMOS input circuit according to Claim 2 or 3, characterized in that the two CMOS inverters (Tp', Tn'; Tp", Tn") are designed to be oppositely asymmetrical in such a way that the ratio of resistance of the two – conductive – transistors, corresponding to the ratio of the quotients (W/L) in each case from channel width (W) and channel length (L) of the one or of the other transistor, is great in comparison to one in the case of the one CMOS inverter, and is small in comparison to one in the case of the other CMOS inverter.

## Revendications

1. Circuit d'entrée C-MOS comportant une résistance pull-up (élévatrice) ou pull-down (réductrice) branchée entre l'entrée du circuit C-MOS et une source de potentiel de service, pour l'établissement du potentiel d'entrée à l'entrée non câblée du circuit, la résistance pull-up ou pull-down étant formée par un circuit à transistors MOS (Tp, Tn), qui forme une résistance commutée, commandée à partir de l'entrée (e) du circuit, et est conducteur uniquement lorsque le potentiel d'entrée appliqué à l'entrée du circuit se situe dans une gamme supérieur à un seuil de commutation, caractérisé par le fait que la résistance pull-up ou pull-down est formée par un circuit à transistors MOS (Tp, Tn), qui est conducteur uniquement dans une plage centrale située entre deux seuils de commutation des transistors et dont un seuil de commutation est proche de la tension de seuil ($V_{TN}$) des transistors MOS possédant un premier type de canal et dont l'autre seuil de commutation est proche de la tension de seuil ($V_{TP}$) des transistors MOS possédant l'autre type de canal.

2. Circuit d'entrée C-MOS suivant la revendication 1, caractérisé par le fait que la résistance pull-up ou pull-down est formée par deux transistors C-MOS (Tp, Tn) branchés en série et commandés par deux inverseurs C-MOS (Tp', Tn'; Tp", Tn") qui sont raccordés, côté d'entrée, à l'entrée (e) du circuit et sont dissymétriques en sens opposé.

3. Circuit d'entrée C-MOS suivant la revendication 1, caractérisé par le fait que la résistance pull-up ou pull-down est formée par deux transistors MOS (Tp1, Tp2) possédant le même type de canal, qui sont branchés en série, et sont commandés directement par l'intermédiaire d'un circuit NON, par deux inverseurs C-MOS (Tp', Tn'; Tp", Tn") qui sont raccordés, côté entrée, à l'entrée (e) du circuit et sont dissymétriques en sens opposé.

4. Circuit d'entrée C-MOS suivant la revendication 1 ou 3, caractérisé par le fait que les deux inverseurs C-MOS (Tp', Tn'; Tp", Tn") sont agencés de manière à être dissymétriques en sens opposé, que le rapport des résistances, qui correspond au rapport des quotients (W/T) de la largeur (W) à la longueur (L) du canal pour le premier et pour le second transistor, des deux transistors – à l'état conducteur – possède une valeur élevée par rapport à l'unité dans l'un des inverseurs C-MOS et une valeur faible par rapport à l'unité dans l'autre des inverseurs C-MOS.

# FIG 1

# FIG 2

FIG 3

FIG 4

FIG 5